# EUROPÄISCHE PATENTANMELDUNG

(11) **EP 2 073 616 A2**
(43) Veröffentlichungstag der Anmeldung: **24.06.2009**
(21) Anmeldenummer: 08019410.3
(22) Anmeldetag: 06.11.2008
(51) Int. Cl.: H05K 7/20

(54) **Geräteeinheit mit Kühlluftkanälen**

(30) Priorität: 21.12.2007 DE 102007062989
(71) Anmelder: Robert Bosch GmbH, 70469 Stuttgart (DE)
(72) Erfinder: Born, Michael, 79846 Partenstein (DE)
(74) Vertreter: Thürer, Andreas

(57) **Zusammenfassung**

Geräteeinheit (1) mit einer Bewegungssteuerung (2) für industrielle Prozesse, die elektrische Antriebe aufweisen, insbesondere einer CNC, und/oder mit einem Antriebsregler (3) für die Regelung von Antrieben, die von einer Bewegungssteuerung zu steuern sind, und insbesondere mit einer Logiksteuerung (4) für industrielle Prozesse, wobei die Geräteeinheit (1) zumindest ein Kühlluftstrommittel (5,6) aufweist, welches einen Kühlluftstrom (7,8,28) erzeugt, der über zumindest zwei benachbarte Kanäle (9,10,11,12) an Verlustleistung erzeugende, elektronische Bauteile (13,14,15,16) und/oder Kühlvorrichtungen (17) und/oder Gehäusewandungen (18,19) geleitet ist, wobei Leiterkarten (20,21,22) der Geräteeinheit (1) und/oder Kühlvorrichtungen (17) und/oder Gehäusewandungen (18,19) zumindest abschnittsweise Wandungen der Kanäle (9,10,11,12) bilden.

## Beschreibung

Die Erfindung betrifft eine Geräteeinheit mit einer Bewegungssteuerung für industrielle Prozesse, wobei die industriellen Prozesse elektrische Antriebe aufweisen, vorzugsweise bestehend aus Elektromotoren und entsprechenden Antriebsregelgeräten. Die Bewegungssteuerung ist insbesondere eine CNC (Computer Numeric Control), weiter insbesondere eine Werkzeugsmaschinensteuerung. Des weiteren hat die Geräteeinheit zusätzlich oder alternativ einen Antriebsregler für die Regelung von Antrieben, die von einer Bewegungssteuerung - insbesondere im obigen Sinne - zu steuern sind. Eine solche Geräteeinheit kann alternativ oder zusätzlich eine Logiksteuerung, zum Beispiel eine sogenannte speicherprogammierbare Steuerung - SPS bzw. PLC (progammable logic control) - aufweisen. Eine solche Geräteeinheit hat ein Kühlluftstrommittel, zum Beispiel einen Lüfter in Form eines elektrisch angetriebenen Ventilators, der z.B. außerhalb oder innerhalb der Geräteeinheit angeordnet ist und einen Kühlluftstrom erzeugt, der über Verlustleistung erzeugende, elektronische Bauteile geleitet ist, so dass die WärmeVerlustleistung von den entsprechenden Bauteilen oder von deren Peripherie abgeführt ist.

Insbesondere betrifft die Erfindung eine Kombination aus einer oben genannten Bewegungssteuerung (Motion Control) und einem Antriebsregler in einem Gehäuse, welches luftstromgekühlt ist und/oder einen Kühlkörper aufweist, zum Beispiel mit Kühlrippen, oder in Kombination einen Luftstromkühler und eine Kühlvorrichtung, zum Beispiel mit Kühlkörper, wobei insbesondere der Luftstrom über Kühlrippen eines solchen Kühlkörpers bzw. einer solchen Kühlvorrichtung geleitet ist.

Eine solche Geräteeinheit für allgemeine elektrische Geräte (nicht für die genannte Integration von Steuerungen und Antrieben) ist aus dem Stand der Technik bekannt.

Eine solche Geräteeinheit ist als allgemeines elektrisches Gerät bekannt; nachteilig dabei ist, dass die genannte Konfiguration eine lediglich stark lokal begrenzte Kühlung der elektrischen, Wärmeverlustleistung erzeugenden Bausteine erlaubt. Dadurch ist im Einzelfall auch dem elektrotechnischen Konstruktionsdesign eine enge Grenze gesetzt.

Es ist daher Aufgabe der vorliegenden Erfindung, eine Aufbauflexibilität und/oder elektrische Konstruktionsdesign-Flexibilität zu verbessern. Alternativ oder zusätzlich ist es Aufgabe der Erfindung, eine gegenüber der oben genannten Konfiguration effizientere Kühlung eines elektrischen Gerätes der eingangs genannten Art anzugeben.

Diese Aufgabe wird gelöst durch die Merkmale des Patentanspruchs 1.

Bei einer Geräteeinheit der eingangs genannten Art wird der durch das Kühlluftstrommittel erzeugte Kühlluftstrom über benachbarte Kanäle an die Verlustleistung erzeugenden, elektronischen Bauteile und/oder Kühlvorrichtungen und/oder Gehäusewandungen geleitet. Dies können mithin Bauelemte oder Strukturelemente oder auch andere Standteile der Geräteinheit oder der gesamten Vorrichtung sein. Diese benachbarten Kanäle werden somit zumindest teilweise durch die genannten Bestandteile als Wandungen aufgebaut. Dies bedeutet, dass zum Beispiel Leiterkarten der Geräteinheiten und/oder Kühlvorrichtungen und/oder Gehäusewandungen und/oder sonstige Strukturelemente oder andere Bestandteile zumindest abschnittsweise Wandungen der genannten Kanäle bilden.

Dadurch wird die Flexibilität erhöht, indem z.B. die Anordnung mehrerer, auch größerer, Verlustleistung erzeugender Bauteile in benachbarten, parallelen Kanälen vorgesehen werden kann. Des weiteren wird die Flexibilität dadurch erhöht, dass die Bauteile geometrisch flexibler anzuordnen sind, z.B. in einem Kanal hintereinander oder über zwei (oder mehr) Kanäle verteilt nebeneinander bzw. übereinander. Trotz dieser flexiblen Anordnung werden die Verlustleistung erzeugenden Bauteile effizient gekühlt. Die Effizienz wird insgesamt durch bedarfsgerechte Strömungsleitung - angesichts der Geometrie, der elektrischen Parameter und der erwarteten Betriebsparameter sowie unter Berücksichtigung der in Betrieb erzeugten Wärmeverlustleistung - bereitgestellt. Dies gilt insbesondere bei Integration mehrerer elektrischer Funktionalitäten (z.B. Bewegungssteuerung und Antriebsregelgerät bzw. Stromversorgung für Elektromotoren) in einem Gehäuse.

Der Luftstrom wird dabei insbesondere praktisch vollständig bis überwiegend innerhalb der Geräteeinheit geleitet. Dazu können beispielsweise auf einer Seite des Gerätes Lufteinlassöffnungen vorgesehen sein, durch die über einen im Gerät hinter den Lufteinlassöffnungen angeordneten Ventilator Luft in das Gerät eingesaugt und durch die Kanäle befördert wird. An der Austrittsseite der Kanäle sind z. B. Austrittsöffnungen aus der Geräteeinheit vorgesehen, so dass insgesamt ein innerer Luftstrom durch die Geräteeinheit entsteht.

Weitere bevorzugte Ausgestaltungen sind - nicht einschränkend - in den Unteransprüchen beschrieben.

Die erfindungsgemäße Geräteeinheit sieht bevorzugt vor, dass eine Bewegungssteuerung für industrielle Prozesse, die elektrische Antriebe aufweisen, insbesondere eine CNC, vorgesehen ist, und dass eine Leiterkarte, die zumindest einen Abschnitt einer Wandung eines Kanals bildet, zumindest ein Zentralsteuermittel der Bewegungssteuerung, insbesondere mit Peripheriekomponenten, aufweist. Eine solche Bewegungssteuerung ist hinsichtlich ihrer Komponenten sehr hochwertig und muss zugleich über eine hohe Funktionssicherheit und Ablaufsicherheit ausgelegt sein. Die empfindlichen Komponenten werden dabei durch die erfindungsgemäße Kühlluft-Konfiguration effizient gekühlt. Dabei kommt auch die Isolationswirkung durch die genannten Kanäle, durch die ein Kühlluftstrom geleitet wird, zur Geltung. Dadurch wird z.B. verhindert, dass von einem nahe gelegenen (z.B. darunter gelegenen) Bauteil Strahlungswärme oder Konvektionswärme auf empfindliche Bauteile der Bewegungssteuerung gelangt. Dadurch kann eine solche Bewegungssteuerung in ein Multifunktionsgerät - insbesondere auch mit elektrischen Bauteilen mit höherer Wärmeverlustleistung - ohne weiteres integriert werden. Durch die Erfindung wird die Integration auch wärmeempfindlicherer Komponenten und/oder auch von Komponenten mit einer geringeren Wärmeverlustleistung ermöglicht. Generell können durch die Erfindung viele Komponenten mit unterschiedlichen, thermischen - insbesondere Verlustleistungs-Eigenschaften und unterschiedlicher thermischer Sensitivität eingesetzt werden.

Gerade bei einer Bewegungssteuerung sind in der Regel keine Halbleiter-Hochleistungsschalter (z.B. IGBT's) vorhanden. Im Vordergrund steht bei einer industriellen Bewegungssteuerung häufig der Aspekt, dass einerseits eine möglichst schnelle und hohe Rechenkapazität in Form einer Zentralprozessoreinheit zur Verfügung gestellt wird. Andererseits können diese Elemente einer Bewegungssteuerung eine erhöhte Wärmeempfindlichkeit aufweisen. Wenn solche Elemente in einem Gehäuse einer Geräteeinheit miteinander kombiniert bzw. integriert sind oder z.B. in benachbarten Leiterkarten verbaut sind, ist eine besonders effiziente Kühlung bei kompakter Bauweise ein entscheidendes Merkmal der Funktionssicherheit und schließlich auch der Marktgängigkeit solcher Geräteeinheiten. Dies hat die Erfindung erkannt und gelöst.

Zusätzlich oder alternativ ist vorgesehen, dass ein Antriebsregler für die Regelung von Antrieben vorgesehen ist, die von einer Bewegungssteuerung zu steuern sind, und dass zumindest eine Leiterkarte, die zumindest einen Abschnitt einer Wandung eines Kanals bildet, zumindest ein Rechenmittel und/oder zumindest ein Gleichrichtermittel zur Bereitstellung einer Zwischenkreisspannung eines Gleichspannungszwischenkreises und/oder zumindest eine Stützkapazität eines Gleichspannungszwischenkreises und/oder zumindest ein nach Maßgabe eines Rechenmittels anzusteuerndes Halbleiter-Leistungsschaltmittel zur Erzeugung einer frequenzregelbaren Ausgangswechselspannung aus einem Gleichspannungszwischenkreis aufweist. Ein solcher Antriebsregler kann z.B. aus einer frequenzregelbaren Spannungsversorgung für angeschlossene Elektromotoren bestehen, und/oder eine Regelstrecke enthalten, die das Ausgangssignal - z.B. die Wechselspannung - nach Maßgabe eines z.B. von einer Bewegungssteuerung zur Verfügung gestellten Sollwertes regelt. Antriebsregler enthalten z.B. eine oben genannte Spannungs-/Stromversorgung und gleichzeitig die Regelung z.B. in einer Baueinheit und/oder in einem Gehäuse. Die Steuerung erfolgt durch eine Bewegungssteuerung, die z.B. die oben genannten Sollwerte liefert.

Bei der erfindungsgemäßen Geräteeinheit ist eine kanalbildende Leiterkarte vorgesehen, die zumindest ein Rechenmittel enthält, welches die Regelung bzw. den Regelalgorithmus aufweist und z.B. aus den Sollwerten die entsprechenden Stellwerte nach Maßgabe der eingestellten Regelung bereitstellt. Ein solches Rechenmittel ist z.B. ein FPGA (Field Programmable Gate Array, das ist ein frei programmierbarer Logikbaustein, der praktisch in allen Bereichen der Digitaltechnik eingesetzt wird, und der auch im Sinne eines erfindungsgemäßen Rechenmittels programmiert sein kann). Alternativ oder zusätzlich kann auch ein Gleichrichtermittel zur Bereitstellung einer Zwischenkreisspannung eines Gleichspannungszwischenkreises des Antriebsreglers auf einer Wandung bildenden Leiterkarte vorhanden sein. Dies bezieht sich z.B. auf einen Antriebsregler, der aus einer gleichgerichteten Zwischenkreisspannung ein frequenzregelbares Ausgangs-Wechselspannungssignal mittels eines Modulationsverfahrens, z.B. mittels Pulsweitenmodulation, erzeugt. Ein solches Gleichrichtermittel kann z.B. eine Hochleistungsdiode aufweisen, die - je nach Spannungshöhe und Strombelag - eine signifikante elektrische Verlustleistung erzeugt und bei deren Integration daher erfindungsgemäße Vorteile einer effizienten Kühlung und/oder höherer Integrationsdichte und/oder kompakter und integrierter Bauweise realisiert werden.

Desgleichen kann alternativ oder zusätzlich zumindest eine Stützkapazität eines Gleichspannungszwischenkreises vorgesehen sein, die z.B. aus - ebenfalls in der Regel einen ziemlich großen Wärmeverlustleistungsbetrag erzeugenden - Kondensatoren, z.B. Elektrolytkondensatoren, bestehen kann. Die Stützkapazität stützt den Gleichspannungszwischenkreis und bietet eine Ladungsreserve, die bei hoher und/oder dynamischer Leistungsentnahme aus dem Gleichspannungszwischenkreis durch die z.B.

Pulsweitenmodulation die Spannungsstabilität des Gleichspannungszwischenkreises gewährleisten soll.

Besonders bevorzugt ist nach der Erfindung eine integrierte Geräteeinheit, die zumindest ein nach Maßgabe eines Rechenmittels zur Regelung von Antrieben, z.B. Elektromotoren, anzusteuerndes Halbleiter-Leistungschaltmittel aufweist. Dieses erzeugt ein frequenzregelbares Ausgangssignal, indem es nach Maßgabe einer z.B. Pulsweitenmodulation die Gleichspannung aus dem Gleichspannungszwischenkreis schaltet. Dabei handelt es sich um ein relevante Verlustleistung erzeugendes Leistungsschaltmittel, z.B. ein IGBT (Internal Gate Bipolar Transistor). In der Regel ist ein Halbleiter-Leistungsschaltmittel zur Ansteuerung einer Achse, also eines z.B. Elektromotors, der eine Automatisierungsachse antreibt, vorgesehen (Elektromotor kann ein Asynchron-Motor oder auch ein Synchronmotor oder Reluktanzmotor sein, wobei in der Automatisierungstechnik in der Regel sowohl rotative Motoren als auch Linearmotoren durch erfindungsgemäße Geräteeinheiten angetrieben werden; eine "Achse" in diesem Sinne ist jeder bewegungsmäßig gesteuerte und/oder geregelte Antrieb, insbesondere einer industriellen Automatisierungsanwendung). Insgesamt ermöglicht die hier genannte erfindungsgemäße Ausgestaltung also eine Integration und effiziente Kühlung und Luftstromleitung (darauf wird später noch näher eingegangen) bei gleichzeitiger Integration verschiedenster, elektrischer Bauteile auch für industrielle Automatisierungsanforderungen unterschiedlichster Eigenschaften und Qualität.

Effiziente Kühlung und Integration wird bei geringem apperativen und Kostenaufwand dadurch ermöglicht, dass eine Geräteeinheit mit den Merkmalen von Anspruch 2 und Anspruch 3 gebildet wird. Das ist eine Integration einer industriellen Bewegungssteuerung mit einem industriellen Antriebsregler in einer Geräteeinheit. Dabei werden die Schaltungen bzw. elektrischen Bauteile dieser unterschiedlichsten, oben genannten Anforderungskategorien miteinander in einem Gehäuse integriert und mit hoher Funktionssicherheit und Standzeit effizient verbaut und durch die erfindungsgemäße Kühlluftstrom-Konfiguration gekühlt.

Die effiziente Luftstromkühlung und -verteilung erlaubt es, ein extrem kompaktes und höchst integriertes Gerät zu erstellen, welches sogar ein integriertes Echtzeit-Kommunikationsmittel aufweisen kann zwischen Bewegungssteuerung und Antriebsregler. Ein solches Echtzeit-Kommunikationsmittel übermittelt Zeit-Sollwerte in Echtzeit - bezogen auf die Echtzeit-Anforderungen der jeweiligen Industrie-Automatisierungsanwendungen.

Die Erfindung stellt eine effiziente und jeweils an die Anforderung der beteiligten Bauteile bzw. Funktionselemente angepasste Kühlfunktion und Luftstromführung dar, wenn ein Strömungsleitschild des Kühlluftstromes vorgesehen ist, das bezüglich der elektrischen Bauteile und der Leiterkarten der Geräteeinheit separat ausgebildet ist und das sich zumindest abschnittsweise mit für die Luftstromführung relevanter Komponente quer zur Strömungsrichtung erstreckt,und zumindest die Luftströmung eines Kanals im für die Luftstromkühlung dieses und/oder eines anderen Kanals relevanten Ausmaß lenkt und/oder schirmt. Ein solches Strömungsleitschild kann innerhalb oder außerhalb eines Kanals angeordnet sein und den entsprechenden Kühlluftstrom teilweise oder praktisch vollständig von einem Kanal abschirmen, in einen anderen Kanal umlenken oder generell innerhalb des Gehäuses führen und/oder lenken und/oder leiten.

Das Strömungsleitschild ist vorzugsweise separat ausgebildet, und insbesondere separat von allen anderen Bauteilen der Geräteeinheit gefertigt. Um die gewünschten Eigenschaften bezüglich der Luftstromführung zu geben, erstreckt sich das Strömungsleitschild zumindest abschnittsweise quer zur lokalen Strömungsrichtung, so dass die Luftströmung eines Kanals bzw. einer generell im Gehäuse vorhandenen Luftströmung, die nicht auf einen Kanal bezogen sein muss, gelenkt, geleitet oder geschirmt wird, und zwar vollständig oder lediglich teilweise. Neben den oben genannten Vorteilen ergibt sich dadurch die Möglichkeit, eine dichtere Integration vorzunehmen und gleichzeitig oder alternativ die Möglichkeit, die Kühlungseffizienz zu erhöhen. Dies kann beispielsweise dadurch geschehen, dass ein Strömungsleitschild eine Strömung von einem Kanal oder von einer lokalen Stelle, an der lediglich Bauteile mit geringer Wärmeverlustleistung vorhanden sind, abhält. Diese Stelle wird dann lediglich in geringem, aber zur Kühlung ausreichendem Maße von der Kühlluft umströmt.

Gleichzeitig oder alternativ kann ein Strömungsleitschild auch dazu vorgesehen sein, einen Teil eines Luftstromes in einen Kanal zu lenken oder von einem Kanal in einen anderen Kanal umzuleiten. Gleichzeitig eröffnet das separate Strömungsleitschild die Möglichkeit, dieses praktisch an jeder geometrisch geeigneten Stelle vorsehen zu können, und zwar quer zur Luftströmungsrichtung an beliebigen Stellen konstruktiv vorzusehen und/oder auch im wesentlichen in Strömungsrichtung gesehen lageveränderlich anzupassen bzw. zu konstruieren.

Um eine effiziente Integration und/oder eine kompakte Bauweise bei flexibler und effizienter Kühlung zu ermöglichen, wird vorgeschlagen, dass der Luftstromweg eines zumindest abschnittsweise bis praktisch vollständig innen zwischen zwei benachbarten Kanälen verlaufenden Innenkanals das Strömungsleitschild aufweist. Vorzugsweise sind drei oder vier oder fünf, z.B. aber auch sechs oder sieben benachbarte Kanäle vorgesehen. Diese können parallel verlaufen. Sie können aber auch - z.B. mit Hilfe eines Strömungsleitschildes - einen abgewinkelten Verlauf aufweisen. Dazu oder zu einem anderen Zweck kann das Strömungsleitschild auch unter aerodynamischen Gesichtspunkten gestaltet sein, z.B. mit einer abgeschrägten Strömungsleitfläche, die die Strömung entlang ihrer Schrägfläche leitet unter Erzeugung möglichst geringer Turbulenzverluste und unter Wahrung möglichst gezielter, reproduzierbarer und vorausberechenbarer Leiteigenschaften.

Das Strömungsleitschild ist in einer bevorzugten Ausführungsform derart angeordnet, dass der Luftstromweg zumindest eines zumindest abschnittsweise bis praktisch vollständig innen zwischen zwei benachbarten Kanälen verlaufenden Innenkanals in vorbestimmtem Sinne beeinflusst wird. Dazu kann ein solcher Innenkanal direkt das Strömungsleitschild aufweisen; dies bedeutet, dass das Strömungsleitschild in oder an einem Innenkanal oder benachbart zu einem Innenkanal angeordnet ist, so dass die diesen Innenkanal betreffende Strömung in obigem Sinne beeinflusst wird.

Eine erhöhte Konstruktionsflexibilität und/oder die bedarfsgerechte Anpassung der Kühlungseigenschaften bezogen auf die Auslegung bzw. Geometrie der Geräteeinheit wird dadurch erreicht, dass das Strömungsleitschild mit seiner Querkomponente lediglich einen Teil des lichten Strömungsquerschnitts eines Kanals deckt, insbesondere einen Teil, in dem in Strömungsrichtung gesehen lediglich elektrische Bauteile mit vergleichsweise geringer elektrischer Verlustleistung angeordnet sind.

Es kann insbesondere eine höhere Integrationsdichte innerhalb der Geräteeinheit erzielt werden und/oder eine flexiblere Anordnung der Bauteile bzw. Funktionseinheiten oder Leiterkarten bei effizienter Kühlung erzielt werden, wenn das Strömungsleitschild zumindest einen Teil eines Kühlluftstromes aus der Flucht oder Teilflucht eines Kanals in einen anderen Kanal umleitet. Dann kann beispielsweise der Abstand zwischen zwei benachbarten Leiterkarten verringert werden oder es können Leiterkarten in einem größeren (quer zur Luftströmungsrichtung gesehen) Abstand platziert werden, wobei dann trotz des größeren Abstands noch darüber oder darunter liegende Kanäle durch die Umleitung und/oder Abzweigung und/oder Verzweigung eines Kühlluftstroms gekühlt werden können.

Ein erhöhter Integrationsgrad und/oder verringerter Aufwand und/oder geringere Kosten bei guten Stabilitäts- und/oder Kühleigenschaften wird dadurch gewährleistet, dass das Strömungsleitschild zusätzlich zu der Strömungsleiteigenschaft zumindest zwei Leiterkarten gegenseitig und/oder gegen Strukturelemente der Geräteeinheit, z.B. eines Gehäuses, mechanisch fixiert. Das Strömungsleitschild hat dann in einem Bauteil eine Doppelfunktion, wie beschrieben. Dazu kann insbesondere vorgesehen sein, dass Leiterkarten in Strömungsrichtung gesehen gegeneinander versetzt angeordnet sind. Z.B. kann eine kleine Leiterkarte in Strömungsrichtung gesehen vor oder hinter einer anderen Leiterkarte sitzen. Diese kleine Leiterkarte kann auch quer zur Strömungsrichtung gegenüber der größeren Leiterkarte verschoben sein, so dass eine Stufe entsteht und diese Stufe beispielsweise mittels eines Strömungsleitschildes mit Doppelfunktion einerseits zur Befestigung bzw. Fixierung der beiden Leiterkarten gegeneinander sowie zur vorbestimmten Leitung des betreffenden Kühlluftstromes oder des betreffenden Kühlluftstromanteils verwendet werden kann.

Um eine einfache Fertigung und/oder einen kostengünstigen Aufbau und/oder eine relativ wenig aufwendige Wartung bzw. Austausch vorsehen zu können, können miteinander korrespondierende mechanische Fixiermittel des Strömungsleitschildes und/oder der Leiterkarten und/oder der Strukturelemente - wie oben angegeben - vorgesehen sein. Dafür kommen insbesondere Rastmittel und/oder (bevorzugt gegenseitige) Führungsmittel und/oder - gegenseitige - Anschlagsmittel und/oder Formschlussmittel und/oder Sitzmittel in Betracht, die bevorzugt eine gegenseitige Fixierung geben.

Bevorzugt ist eine solche Fixierung zur leichteren Montage und Wartung lösbar.

Um die Vorteile der Erfindung durch Massenfertigung erhöhen zu können und/oder um einen möglichst bedarfsgemäß flexiblen konstruktiven Aufbau zu gestatten, ist das Strömungsleitschild ein Kunststoffteil, und insbesondere ein Kunststoffspritzgießteil.

Als Kühlluftstrommittel dient ein Lüfter. Insbesondere sind zwei oder drei oder mehr Lüfter vorgesehen, so dass die erfindungsgemäßen Vorteile durch einen aktiven Luftstrom weiter gefördert werden.

Insgesamt bietet die Erfindung ein - vorzugsweiße hoch integriertes - effizient gekühltes, damit mit hoher Standzeit und hoher Funktionssicherheit ausgestattetes Kombinationsgerät für industrielle Anwendungen, z.B. Werkzeugmaschinen, industrielle Fertigungsmaschinen, Druckmaschinen, oder andere automatisierte Fertigungsanlagen, bei denen elektrische Antriebe mit Elektromotoren und Antriebsreglern sowie präzise Bewegungssteuerungen verwendet werden.

Die Erfindung wird anhand von Ausführungsbeispielen, die in den Figuren schematisch gezeigt sind, näher erläutert. Die Erläuterung ist lediglich beispielhaft und schränkt die Erfindung nicht auf die gezeigten Ausführungsbeispiele ein. Es zeigen:
Figur 1 eine perspektivische Ansicht einer Geräteeinheit im zusammengebauten Zustand, insbesondere mit Gehäuseabdeckung, wobei die Anschlussmittel für anzuschließende Steuerungs- und Antriebskomponenten weggelassen sind,
Figur 1a eine Draufsicht von oben auf das Ausführungsbeispiel der Figur 1,
Figur 2 eine perspektivische Ansicht des Ausführungsbeispiels der Figuren 1 und 1a, wobei Gehäuseteile und Deckelteile abgenommen sind und eine Konfiguration oben liegender Leiterkarten sichtbar ist,
Figur 3 einen Längsschnitt durch die Geräteeinheit, wie in Figur 1a mit III angegeben, wobei verschiedene Leiterkartenebenen und dazwischen liegende Kanäle und Kühlluftströme sichtbar sind,
Figur 4 eine perspektivische Ansicht eines Strömungsleitschildes,
Figur 5a eine perspektivische Ansicht des Strömungsleitschildes der Figur 4, wobei verschiedene Schnittebenen eingezeichnet sind,
Figur 5b eine Ansicht des Strömungsleitschildes von hinten,
Figur 5c eine Draufsicht auf das Strömungsleitschild,
Figur 5d eine Draufsicht auf das Strömungsleitschild aus anderer Perspektive,
Figur 5e, f, g, jeweils Schnittzeichnungen bzw. Ansichten wie in den Figuren 5a und 5d eingezeichnet.

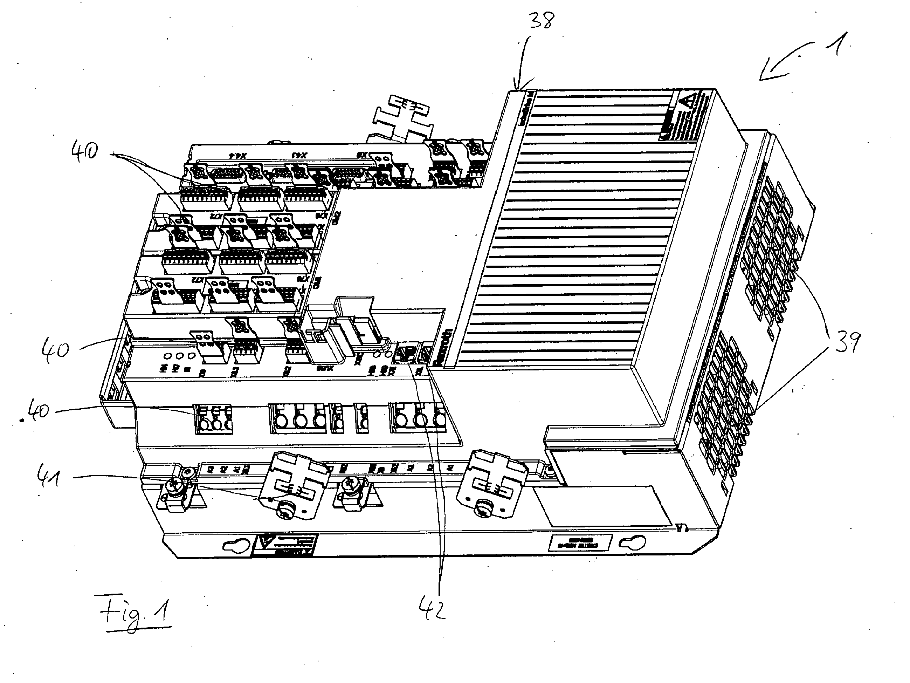

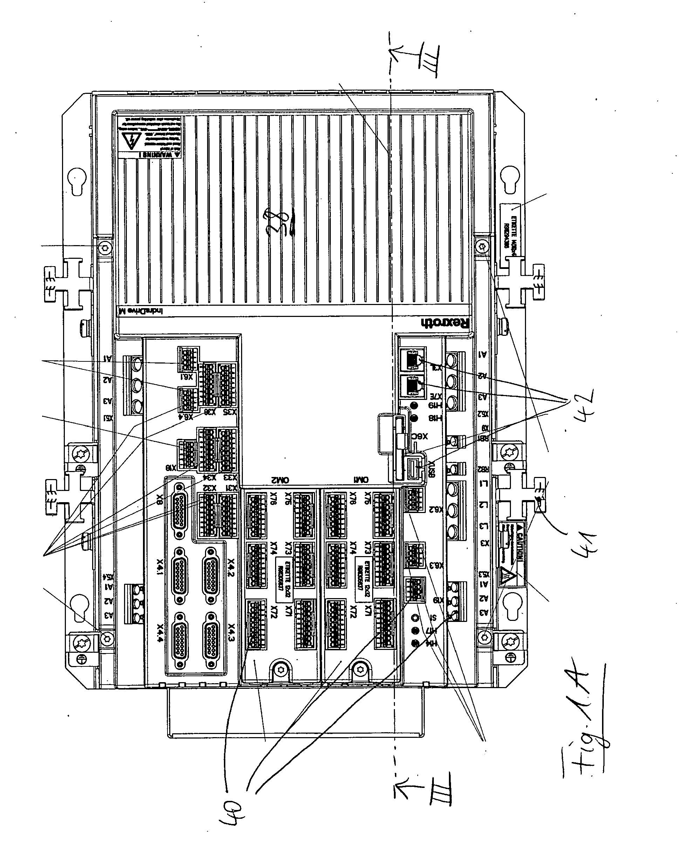

Figur 1 zeigt die perspektivische Ansicht der Geräteeinheit 1, wobei die Geräteeinheit 1 in der Figur 1 gesehen rechtsseitig mit einem Gehäusedeckel 38 abgedeckt ist. Der Gehäusedeckel 38 schützt zunächst vor Eingriff, kann aber auch eine bestimmte Schutzklasse, z.B. IP65, aufweisen. Die Geräteeinheit 1 hat eine Bewegungssteuerung für industrielle Prozesse, die elektrische Antriebe aufweisen, insbesondere eine CNC. Sie hat des weiteren einen oder mehrere Antriebsregler für die Regelung von Antrieben, z.B. Elektromotoren, die von einer Bewegungssteuerung und/oder von der integrierten Bewegungssteuerung zu steuern sind. Die Geräteeinheit hat insbesondere noch eine Logiksteuerung (SPS/PLC für industrielle Prozesse), die hier aber nicht gezeigt ist. In der Figur 1 ist noch zu erkennen, dass für die entsprechenden Funktionalitäten der Geräteeinheit entsprechende Anschlussbuchsen/Anschlussklemmen 40 vorgesehen sind. Die Anschlussklemmen oder Anschlussbuchsen 40 dienen zum Anschluss der entsprechenden Komponenten, z.B. Elektromotoren, Peripheriekomponenten und dergleichen, die mit der Geräteeinheit 1 verbunden werden. Des weiteren sind noch Erdanschlussklemmen 41 seitlich herausgeführt vorgesehen, die einen einfachen Erdanschluss im Inneren des Gehäuses bieten und diesen Erdanschluss herausführen. Das hat den Vorteil, dass ebenfalls integriert Erdanschlüsse vorhanden sind für alle Komponenten, die in einem Gehäuse gleiches Erdpotenzial ohne durch z.B. voneinander entfernte Anbringung entstandene Abweichung der Erdpotenziale bietet.

Des weiteren sind Kommunikationsanschlüsse und/oder Wartungsanschlüsse 42 vorhanden. Diese dienen z.B. dem Anschluss eines Wartungsgerätes, z.B. eines Notebooks zur Konfiguration und/oder zur Steuerung der in der Geräteeinheit 1 integrierten Funktionen. Es kann sich dabei z.B. um einen Ethernet-Anschluss, z.B. für einer der zahlreichen Industrial Ethernet-Anschlussstandards wie z.B. SERCOS handeln.

In der Draufsicht der Figur 1 a ist zu sehen, dass die entsprechenden Anschlussbuchsen 40, Erdanschlussklemmen 41, Kommunikations- und Wartungsanschlüsse 42 (hiervon kann auch ein USB-Anschluss umfasst sein) mit entsprechenden Beschriftungen versehen sind, so dass Verwechslungen beim Anschluss ausgeschlossen sind. Z.B. kann es sich bei der Geräteeinheit 1 um eine Geräteeinheit 1 zur Steuerung und/oder zum Antrieb von 2, 3, vier, 5 oder mehr oder weniger Achsen handeln. Dann sind die entsprechenden Achsanschlüsse z.B. mit einer alphanumerischen Erweiterung gekennzeichnet, die sich z.B. auf die Achsen bezieht. Bei vier Achsen kann z.B. ein Anschluss für die jeweilige Achse mit n.1 für die erste Achse, n.2 für die zweite Achse und so fort gekennzeichnet sein. Außerdem sind jeweils gleiche Anschlussstandards (z.B. RS232-Anschlüsse) in geometrisch zusammengehörigen und entsprechend gekennzeichneten Abschnitten zusammengefasst; dies gilt jedoch nur für einen Teil der Anschlüsse. Gleiche Anschlussstandards für verschiedene Achsen können auch auf entgegen gesetzten Seiten, z.B. entgegen gesetzten Längsseiten, der Geräteeinheit 1 angeordnet sein.

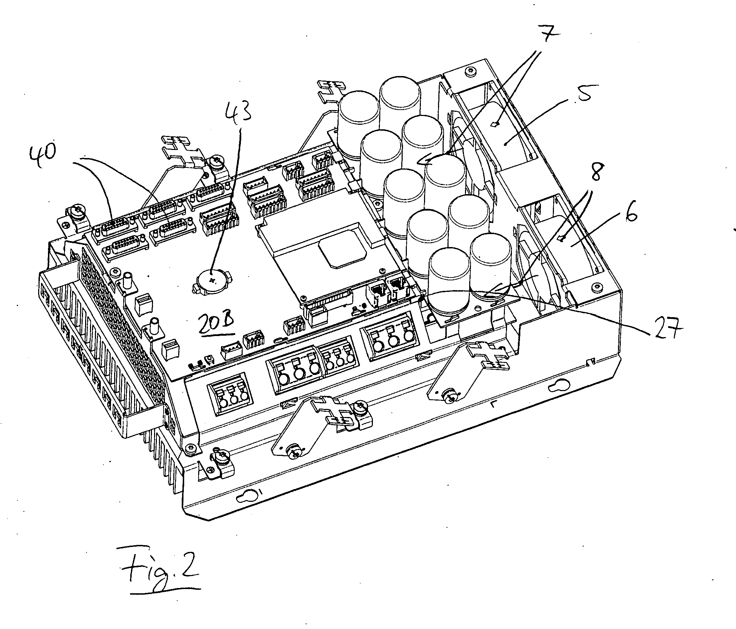

In Figur 2 ist der Gehäusedeckel 38 und sind Abdeckungen für die Leiterkarten (linksseitig) entfernt. Dadurch ist eine erste Ebene von Leiterkarten mit elektrischen Bauteilen zu sehen. Insbesondere ist zu sehen, dass die Geräteeinheit 1 zwei Kühlluftstrommittel 5,6, nämlich Lüfter 5,6 aufweist, die Kühlluftströme 7,8 erzeugen. Die Kühlluftstrommittel 5,6 sind in Längsrichtung gesehen rechtsseitig am Ende der Geräteeinheit 1 angebracht. Es sind zwei in Querrichtung benachbarte Luftstrommittel 5,6 vorgesehen, die eine praktisch quer und in Höhenrichtung vollständige Beschickung des Innenraumes der Geräteeinheit 1 mit Luftströmen 7,8 gewährleisten. Zu sehen ist in dem Ausführungsbeispiel der Figur 2 auch, dass auf der B-Seite 20B der Leiterkarte 20 eine Pufferbatterie 43 vorhanden ist.

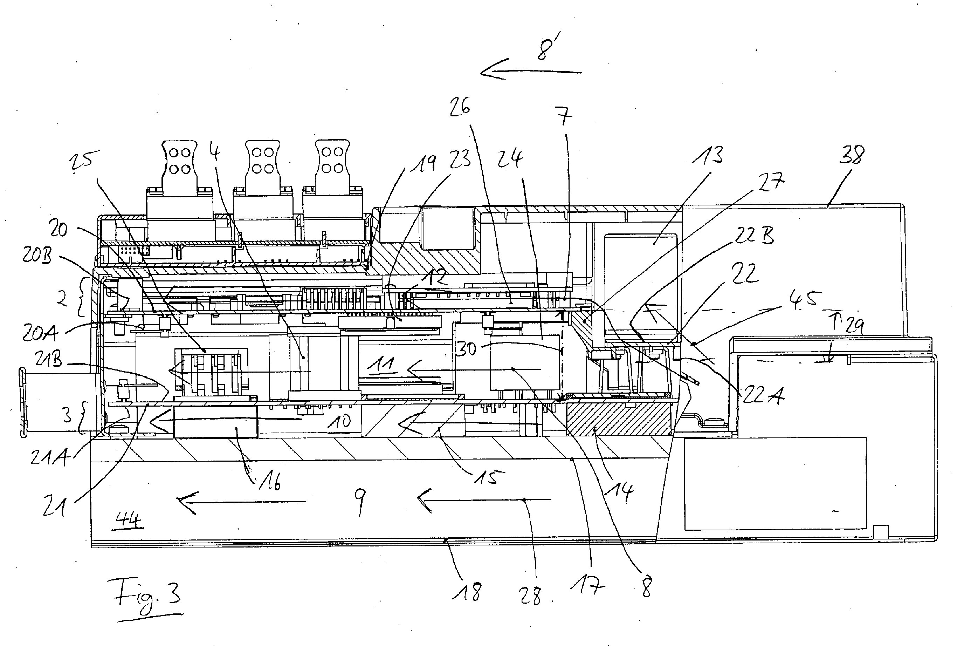

In Figur 3 schließlich ist einerseits teilweise der schaltungstechnische Aufbau und andererseits die Kühlluftstromführung der Geräteeinheit 1 zu sehen. Der Schnitt der Figur 3 ist dabei in vollständig mit einem Gehäuse 38 und einer Deckelwandung 19 bedeckter Konfiguration ausgeführt. Dadurch ist - der besseren Übersichtlichkeit halber - Gehäusedeckel 38 und/oder Deckelwandung 19 teilweise gezeigt, teilweise aufgelassen bzw. unterbrochen und teilweise geschnitten.

Es ist ein Bewegungssteuerungs-Modul 2, ein Antriebsregler-Modul 3 und ein Logiksteuerungs-Modul 4 vorhanden. Die genannten Module 2,3,4 haben entsprechende elektrische Baugruppen. Diese Baugruppen sind jeweils effizient verteilt auf entsprechenden Leiterkarten untergebracht. Es ist eine Bewegungssteuerungs-Leiterkarte 20 vorhanden. Auf der B-Seite 20B der Bewegungssteuerungs-Leiterkarte 20 ist unter anderem eine Pufferbatterie 43 und sind einige Anschlussbuchsen-Steckmittel vorhanden. Auf der A-Seite 20A der Leiterkarte 20 sind unter anderem Bauteile des Bewegungssteuerungs-Moduls 2 vorhanden, unter anderem das Zentralsteuermittel 23, welches eine hochintegrierte, elektrische Halbleiterschaltung sein kann.

Die Antriebsleistungs-Leiterkarte 21 hat ebenfalls eine A-Seite 21A und eine B-Seite 21 B, auf der A-Seite 21 A sind Leistungsschaltmittel 14, 16 und Diodenmittel 15 vorhanden, die eine Schaltung der Leistung für jeweils eine angetriebene Achse, zum Beispiel im Sinne einer pulsweitenmodulierten Leistungshalbleiter-Schaltung (IGBT) bieten sowie eine Gleichrichtung zum Beispiel eines Gleichspannungszwischenkreises für die Bereitstellung der Gleichspannungszwischenkreise für die Leistungsversorgung von pulsweitenmoduliert angetriebenen Elektromotoren.

Insgesamt sind auf den gezeigten Leiterkarten 20, 21, 22 elektrische und/oder elektronische Bauteile 4, 23, 24, 25, 26 angeordnet; für die Anordnung und elektrische Kontaktierung und (auch gegenseitige) Befestigung sind an den Leiterkarten 20, 21, 22 jeweils die A-Seiten 20A, 21A, 22A und/oder die B-Seiten 20B, 21 B, 22B genutzt. Elektrische Bauteile, die auf der jeweiligen A- oder B-Seite der jeweiligen Leiterkarten 20, 21, 22 angeordnet sein können, sind: Logiksteuerungs-Modul (ggf. mit dazu gehöriger peripherer Elektronik und/oder Mikrochip, Mikrocontroller, FPGA, ASIC oder dergleichen), Zentralsteuermittel (ggf. mit dazu gehöriger peripherer Elektronik und/oder Mikrochip, Mikrocontroller, FPGA, ASIC, DSP oder dergleichen), weitere allgemeine elektrische oder elektronische (Peripherie-) Komponenten, Rechenmittel für das Steuermittel und/oder für das Regelmittel, z.B. ein FPGA, Echtzeit-Kommunikationsmittel, z.B. eine Feldbuskarte oder ein Feldbus-Interface, aber auch eine Feldbus-Interface-Emulationsschaltung (z.B. mit Multi- oder Dualport-RAM), welche zumindest einen Feldbus, z.B. SERCOS, vorzugsweise in einem Gehäuse emuliert und weiter vorzugsweise Antriebssteuerung und Antriebsregler in einem Gehäuse miteinander in Echtzeit kommunizieren lässt.

Die Kühlluftstrommittel 5,6 (rechtsseitig in Figur 3 gezeigt) erzeugen einen Kühlluftstrom 7,8,28,45, der - wie in der Figur 3 gezeigt - in Teilluftströme aufgeteilt ist bzw. durch die Anordnung von benachbarten Kanälen 9,10,11,12 und Führungs- und/oder Leitungsmitteln für den Kühlluftstrom geführt und/oder aufgeteilt ist.

Hierzu bilden die benachbarten Kanäle 9,10,11,12 Leitungen für die Kühlluftströme 7,8,28,45. Dadurch werden die Kühlluftströme 7,8,28,45 an Verlustleistung erzeugende, elektrische und/oder elektronische Bauteile und/oder eine Kühlvorrichtung 17, nämlich z. B. eine Kühlvorrichtung 17 mit Kühlrippen 44, geleitet. Dadurch werden die entsprechenden elektrischen und/oder elektronische Bauteile 13,14,15,16,4 23,24,25,26 entsprechend gekühlt und/oder die Kühlvorrichtung 17 selber gekühlt bzw. von der Kühlvorrichtung 17 aufgenommene Wärme entzogen und aus dem Gehäuse abgeführt.

Die Leiterkarten 20,21,22 der Geräteeinheit 1 und/oder die Kühlvorrichtung 17 und/oder Wandungen 18, 19 des Gehäuses bilden dabei zumindest abschnittsweise Wandungen der genannten Kanäle 9,10, 11,12. In dem gezeigten Ausführungsbeispiel sind im wesentlichen vier Kanäle 9,10,11,12 vorhanden. Der Kanal 9 führt den Luftstrom 28 durch die Kühlvorrichtung 17, und zwar entlang und zwischen Kühlrippen 44, so dass dadurch effizient von den Kühlrippen 44 die Wärme getauscht wird. Der Kanal 9 ist oberseitig durch die Decke der Kühlvorrichtung 17 und unterseitig durch eine Bodenwandung 18 begrenzt. Im gezeigten Ausführungsbeispiel tritt der Luftstrom generell rechts, durch das Lüfterdoppel 5,6 erzeugt, ein und auf der linken Seite aus dem Gehäuse aus. Es kann auch eine interne, teilweise oder vollständig geschlossene Umluftzirkulation vorgesehen sein. Der Kanal 10 (in Figur 3 oberhalb von Kanal 9 gelegen) ist ein relativ schmaler Kanal, der fast zentral bzw. nur leicht außermittig bezüglich der Flucht beider Kühlluftstrommittel oder zumindest eines Kühlluftstrommittels 5,6 liegt, so dass der Kanal 10 direkt, d. h. insbesondere ohne größere Umlenkung und radial bezüglich eines Lüfters 5,6 gesehen ziemlich nahe oder im Bereich großer oder höchster Lüfterstärke angeordnet ist. Dafür sind in dem Kanal 10 auch starke Verlustleistung erzeugende Bauteiln 14, 15,16, nämlich die Diodenmittel 15 und Leistungschaltmittel 14,16 angeordnet. Von diesen elektrischen Bauteilen wird die Abwärme durch die gezeigte Konfiguration über den Kanal besonders effizient abgeführt, wobei gleichzeitig noch ausreichend Kühlluftstrom für andere Bauteile bzw. zur Abführung bzw. zum Wärmetausch vorhanden ist. Der Kanal 10 wird unterseitig durch die Decke des Kühlmittels 17 bzw. des Kühlkörpers 17 begrenzt und oberseitig durch (insbesondere die A-Seite 21A) die Antriebsleistungs-Leiterkarte 21 begrenzt.

Der über dem Kanal 10 gelegene Kanal 11 liegt immer noch teilweise in der direkten Projektion bzw. Flucht eines oder beider Lüfter 5,6. Der Luftstrom wird allenfalls wenig in den Kanal 11 umgelenkt und streicht über die elektrischen Bauteile 24,4,25 (lediglich beispielhaft). Der Kühlluftstrom tritt linksseitig durch die gezeigte Öffnung des Gehäuses aus, konnte aber in einer alternativen Ausgestaltung auch an anderer Stelle austreten oder umgelenkt werden und/oder oberseitig und/oder unterseitig austreten und zum Beispiel auch innerhalb des Gehäuses als gänzlicher oder teilweiser Umluftstrom geführt sein. Die Begrenzung des Kanals 11 wird wiederum durch zwei Leiterkarten 20,21 gebildet.

Der Luftstrom 7 verläuft oberhalb des Luftstromes 8 (durch den Kanal 11 verläuft). Der Luftstrom 7 wird durch das Strömungsleitschild 27 in den Kanal 12 zwischen der Leiterkarte 20 und der Deckelwandung 19 des Gehäuses der Geräteeinheit geführt und kühlt dort bzw. überstreicht dort die Bauteile 26 darauf (lediglich beispielhaft, es können auch noch andere Bauteile von diesem oder jenem anderen Luftstrom überstrichen werden).

Auch der (Teil-) Luftstrom 7 tritt linksseitig des Gehäuses durch die dort gezeigte Öffnung aus. Es gilt insoweit aber auch das für alle anderen Luftströmung gesagte bezüglich Austriftsmöglichkeit und Umluftalternative.

Das Strömungsleitschild 27 ist bezüglich der elektrischen Bauteile 13,14, 15,16,4,23,24, 25,26 separat ausgebildet und erstreckt sich zumindest abschnittsweise mit für die Luftstromführung relevanter Komponente 29 quer zur Strömungsrichtung. Es lenkt dadurch zumindest einen Teil des Kühlluftstromes in für die Luftstromkühlung eines Kanals 12, 11 relevanten Ausmaß. Dies bedeutet im Einzelnen, dass z. B. ein Teil des gesamten Kühlluftstromes von dem Kanal 11 oberseitig durch das Strömuhgsleitschild 27 abgeschirmt wird, unterseitig jedoch ein Teil noch durchgelassen wird, so däss für z. B. in Kanal 11 angeordnete, relativ wenig Verlustleistung erzeugende Bauteile immer noch ausreichend Kühlluftstromdurchfluss vorhanden ist. Andererseits wird nicht nur ein Teil des Kühlluftstromes vom Kanal 11 abgeschirmt, sondern dieser Teil wird gleichzeitig teilweise oder vollständig in den Kanal 12 umgelenkt, so dass eine größere Stapelhöhe bzw. eine größere Bauhöhe und eine größere Höhe für die Anordnung von Leiterkarten zur Verfügung steht. Das Strömungsleitschild 27 deckt also mit seiner Querkomponente 29 lediglich einen Teil des lichten Strömungsquerschnitts 30 des Kanals 11 ab und leitet somit auch nur diesen Teil in den Kanal 12 um. In dem Kanal 11 liegen dann in Strömungsrichtung 8' gesehen lediglich elektrische und/oder elektronische Bauteile 4,24,25 mit relativ geringer, elektrischer Verlustleistung. Daher kann durch das Strömungsleitschild 27 ein Teil des Kühlluftstromes aus der Flucht oder aus der Teilflucht des Kanals 11 in den Kanal 12 umgeleitet werden. Gleichzeitig fixiert das Strömungsleitschild 27 zusätzlich zu der Strömungsleiteigenschaft die Leiterkarten 20 und 22 relativ zueinander. Die Leiterkarte 22 trägt auf ihrer B-Seite 22B einen oder mehrere Kondensatoren 13 zur Stützung des Gleichspannungszwischenkreises. Daher ist diese Leiterkarte 22 mit den Kondensatoren 13 zwar nicht direkt im radialen Höchstleistungsbereich der Lüfter 5,6 angeordnet, aber einerseits rechtsseitig in Längsrichtung gesehen nahe am Austritt des Luftstromes aus den Lüftern 5,6 gelegen und andererseits von dem Kühlluftstrom 45 umströmt, der durch das Strömungsleitschild 27 gebildet wird. Auf diese sehr effiziente Weise kann eine extrem große Baudichte und ein extrem hoher Integrationsgrad erreicht werden. Ein solch hoher Integrationsgrad ist durch die erfindungsgemäße Leistung erst effizient ermöglicht.

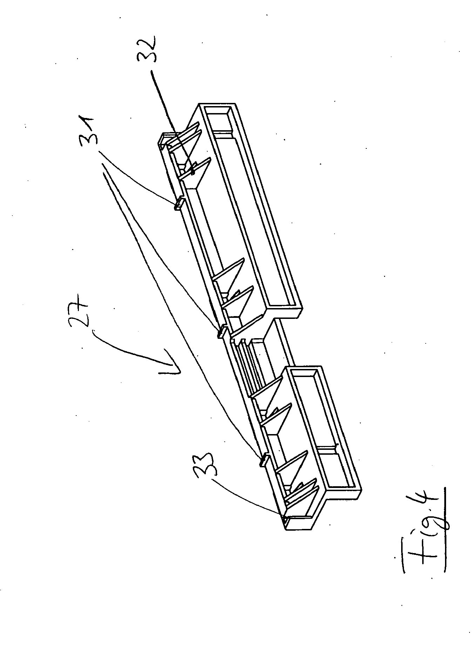

Figur 4 zeigt das Strömungsleitschild 27 in perspektivischer Ansicht. Auf dem Strömungsleitschild 27 sind Stege 31 vorhanden, die der Führung und formschlüssigen Festsetzung einerseits dienen. Andererseits sind Ausnehmungen 33 vorhanden, die als Aufnahme für ebenfalls einen formschlüssigen oder auch einen Klemm- oder Presssitz dienen können. Schließlich sind in Figur 4 noch Streben 32 zur strukturellen Versteifung und ggf. ebenfalls zur gegenseitigen Führung und/oder zur Begünstigung der Strömungseigenschaften und/oder für anderweitige geometrische Aufgaben vorhanden.

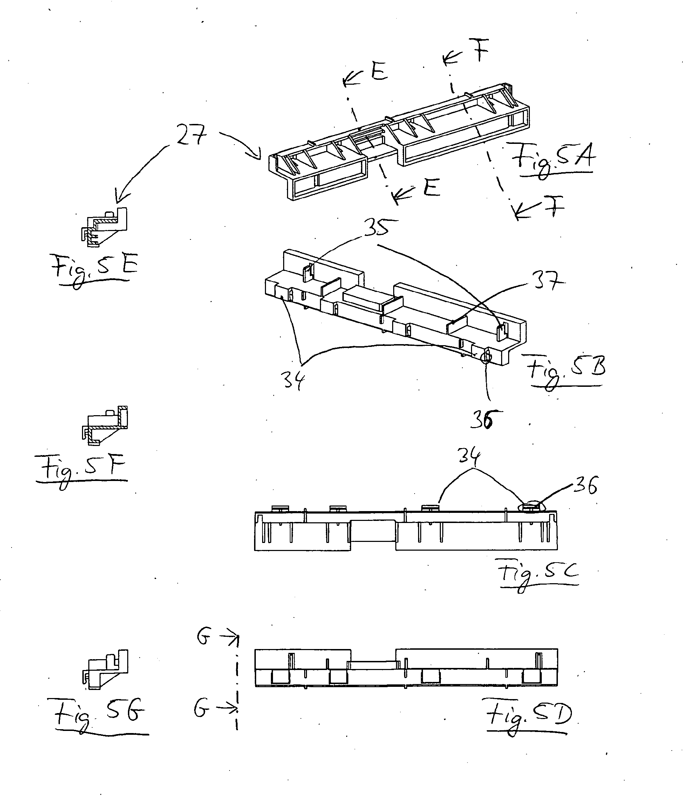

Die Figuren 5 A,B,C,D,E,F,G zeigen jeweils noch in perspektivischer Ansicht und in direkter Draufsicht, dass das Strömungsleitschild 27 noch Sitzmittel 34,35 in Form von Rasthaken und/oder Hinterschneidungen und/oder Haken aufweist, um Leiterkarten aneinander, relativ zueinander, oder gegenseitig zu sichern. Gleichzeitig kann auch ein solcher Strömungsleitschild 27 dazu dienen, Leiterkarten gegeneinander und/oder an einem Gehäuse mit den genannten Mitteln zu arretieren, zu befestigen oder lediglich zu sichern.

Des weiteren ist in Figur 5B besonders gut zu sehen, das die Rastnasen 36 einen kleinen Raststeg haben zur Verrastung bzw. zur sicheren Befestigung der entsprechenden Leiterkarte bzw. des entsprechenden Sicherungsteiles.

### Bezugszeichenliste

- 1: Geräteeinheit
- 2: Bewegungssteuerungs-Modul
- 3: Antriebsregler-Modul
- 4: elektrisches Bauteil
- 5: Kühlluftstrommittel/Lüfter
- 6: Kühlluftstrommittel/Lüfter
- 7: Kühlluftstrom
- 8: Kühlluftstrom; 8' Luftstromrichtung/Längsrichtung
- 9: Kanal
- 10: Kanal
- 11: Kanal
- 12: Kanal
- 13: Kondensator
- 14: Leistungsschaltmittel
- 15: Diodenmittel
- 16: Leistungsschaltmittel
- 17: Kühlmittel/Kühlkörper
- 18: Bodenwandung
- 19: Deckelwandung
- 20: Bewegungssteuerungs-Leiterkarte
- 21: Antriebsleistungs-Leiterkarte
- 22: Kondensator-Leiterkarte
- 20A: A-Seite der Leiterkarte 20
- 21A: A-Seite der Leiterkarte 21
- 22A: A-Seite der Leiterkarte 22
- 20B: B-Seite der Leiterkarte 20
- 21 B: B-Seite der Leiterkarte 21
- 22B: B-Seite der Leiterkarte 22
- 23: elektrisches Bauteil
- 24: elektrisches Bauteil
- 25: elektrisches Bauteil
- 26: elektrisches Bauteil
- 27: Strömungsleitschild
- 28: Kühlluftstrom
- 29: Querkomponente zur Strömungsrichtung
- 30: lichter Strömungsquerschnitt
- 31: Steg
- 32: Strebe
- 33: Ausnehmung
- 34: Sitzmittel
- 35: Sitzmittel
- 36: Rastnase
- 37: Formschlussmittel
- 38: Gehäusedeckel
- 39: Lüftergitter
- 40: Anschlussbuchsen/Anschlussklemmen
- 41: Erdanschlussklemmen
- 42: Kommunikations-/Wartungsanschluss
- 43: Pufferbatterie
- 44: Kühlrippe
- 45: Kühlluftstrom

## Patentansprüche

1. Geräteeinheit (1) mit einer Bewegungssteuerung (2) für industrielle Prozesse, die elektrische Antriebe aufweisen, insbesondere einer CNC, und/oder mit einem Antriebsregler (3) für die Regelung von Antrieben, die von einer Bewegungssteuerung zu steuern sind, und insbesondere mit einer Logiksteuerung (4) für industrielle Prozesse, wobei die Geräteeinheit (1) zumindest ein Kühlluftstrommittel (5,6) aufweist, welches einen Kühlluftstrom (7,8,28) erzeugt, der über zumindest zwei benachbarte Kanäle (9,10,11,12) an Verlustleistung erzeugende, elektronische Bauteile (13,14,15,16) und/oder Kühlvorrichtungen (17) und/oder Gehäusewandungen (18,19) geleitet ist, wobei Leiterkarten (20,21,22) der Geräteeinheit (1) und/oder Kühlvorrichtungen (17) und/oder Gehäusewandungen (18,19) zumindest abschnittsweise Wandungen der Kanäle (9,10,11,12) bilden.

2. Geräteeinheit nach Anspruch 1, **dadurch gekennzeichnet, dass** eine Bewegungssteuerung für industrielle Prozesse, die elektrische Antriebe aufweisen, insbesondere eine CNC, vorgesehen ist, und dass eine Leiterkarte (20), die zumindest einen Abschnitt einer Wandung eines Kanals (11,12) bildet, zumindest ein Zentralsteuermittel (23) der Bewegungssteuerung, insbesondere mit Peripheriekomponenten (24), aufweist.

3. Geräteeinheit nach Anspruch 1 oder 2, **dadurch gekennzeichnet, dass** ein Antriebsregler für die Regelung von Antrieben vorgesehen ist, die von einer Bewegungssteuerung zu steuern sind, und dass zumindest eine Leiterkarte (21), die zumindest einen Abschnitt einer Wandung eines Kanals (10,11) bildet, zumindest ein Rechenmittel (25) und/oder zumindest ein Gleichrichtermittel (15) zur Bereitstellung einer Zwischenkreisspannung eines Gleichspannungszwischenkreises und/oder zumindest eine Stützkapazität (13) eines Gleichspannungszwischenkreises und/oder zumindest ein nach Maßgabe eines Rechenmittels anzusteuerndes Halbleiter-Leistungsschaltmittel (14,16) zur Erzeugung einer frequenzregelbaren Ausgangswechselspannung aus einem Gleichspannungszwischenkreis aufweist.

4. Geräteeinheit nach Anspruch 2 und 3.

5. Geräteeinheit nach Anspruch 4, **dadurch gekennzeichnet, dass** ein integriertes Echtzeit-Kommunikationsmittel (26) vorgesehen ist zwischen Bewegungssteuerung und Antriebsregler, welches zumindest Echtzeit-Sollwerte übermittelt.

6. Geräteeinheit nach einem der Ansprüche 1 bis 5, **dadurch gekennzeichnet, dass** ein Strömungsleitschild (27) des Kühlluftstromes (7,8,28) vorgesehen ist, das bezüglich der elektrischen Bauteile und der Leiterkarten (20,21,22) der Geräteeinheit (1) separat ausgebildet ist und das sich zumindest abschnittsweise mit für die Luftstromführung relevanter Komponente (29) quer zur, insbesondere lokalen, Strömungsrichtung erstreckt und zumindest die Luftströmung (7,8) eines Kanals (11,12) im für die Luftstromkühlung dieses und/oder eines anderen Kanals (11,12) relevanten Ausmaß lenkt und/oder schirmt.

7. Geräteeinheit nach Anspruch 6, **dadurch gekennzeichnet, dass** drei oder vier oder fünf oder mehr benachbarte, zumindest abschnittsweise bis praktisch vollständig parallel verlaufende Kanäle (9,10,11,12) vorgesehen sind.

8. Geräteeinheit nach Anspruch 7, **dadurch gekennzeichnet, dass** der Luftstromweg eines zumindest abschnittsweise bis praktisch vollständig innen zwischen zwei benachbarten Kanälen (10,12) verlaufenden Innenkanals (11) das Strömungsleitschild (27) aufweist.

9. Geräteeinheit nach einem der Ansprüche 6 bis 8, **dadurch gekennzeichnet, dass** das Strömungsleitschild (27) mit seiner Querkomponente (29) lediglich einen Teil des lichten Strömungsquerschnitts (30) eines Kanals (11) deckt, insbesondere einen Teil, in dem in Strömungsrichtung (8) gesehen lediglich elektrische Bauteile (23) mit vergleichsweise geringer elektrischer Verlustleistung angeordnet sind.

10. Geräteeinheit nach einem der Ansprüche 6 bis 9, **dadurch gekennzeichnet, dass** das Strömungsleitschild (27) zumindest einen Teil eines Kühlluftstromes (7,8) aus der Flucht oder Teilflucht eines Kanals (11) in einen anderen Kanal (12) umleitet.

11. Geräteeinheit nach einem der Ansprüche 6 bis 10, **dadurch gekennzeichnet, dass** das Strömungsleitschild (27) zusätzlich zu der Strömungsleiteigenschaft zumindest zwei Leiterkarten (20,22) gegenseitig und/oder gegen Strukturelemente der Geräteeinheit, z.B. eines Gehäuses, mechanisch fixiert.

12. Geräteeinheit nach Anspruch 11, **dadurch gekennzeichnet, dass** miteinander korrespondierende mechanische Fixiermittel des Strömungsleitschildes (27) und/oder der Leiterkarten und/oder der Strukturelemente vorgesehen sind, insbesondere Rastmittel und/oder Führungsmittel und/oder Anschlagsmittel und/oder Formschlussmittel und/oder Sitzmittel, die eine gegenseitige Fixierung geben.

13. Geräteeinheit nach Anspruch11 oder 12, **dadurch gekennzeichnet, dass** eine lösbare Fixierung vorgesehen ist.

14. Geräteeinheit einem der Ansprüche 6 bis 13, **dadurch gekennzeichnet, dass** das Strömungsleitschild (27) ein Kunststoffteil, insbesondere ein Kunststoffspritzgießteil, ist.

15. Geräteeinheit einem der Ansprüche 1 bis 14, **dadurch gekennzeichnet, dass** als Kühlluftstrommittel ein Lüfter (5,6) oder zwei oder drei oder mehr Lüfter (5,6) vorgesehen sind.
